# EUROPEAN PATENT APPLICATION

(11) **EP 1 732 280 A1**
(43) Date of publication of application: **13.12.2006**
(21) Application number: 05719308.8
(22) Date of filing: 18.02.2005
(51) Int. Cl.: H04L 27/02

(54) **NETWORK SYSTEM**

(30) Priority: 30.03.2004 JP 2004099236
(71) Applicant: SANYO ELECTRIC CO., LTD., Moriguchi City, Osaka 570-8677 (JP)
(72) Inventor: NISHIMURA, Masaaki c/o Sanyo Electric Co., Ltd., Osaka 5708677 (JP); SUZUKI, Hirohisa c/o Sanyo Electric Co., Ltd., Osaka 5708677 (JP)
(74) Representative: Röss, Walter Josef Alfred
(86) International application number: PCT/JP2005/002639
(87) International publication number: WO 2005/099207

(57) **Abstract**

When a transmitter device connected to a network system outputs a digital signal subjected to bi-phase modulation, a complicated detection circuit for detecting a digital signal is required on the receiver side. Therefore, in an interface device (4) which intervenes between the transmitter device and a communication path (6), transmission data S subjected to bi-phase modulation is converted into a transmission signal subjected to amplitude shift modulation, and the resultant transmission signal is output to the communication path (6). The interface device (4) converts the transmission data S into an NRZ modulated digital signal in the modulation method conversion circuit (12). The amplitude modulation circuit (14) modulates the amplitudes of a carrier wave according to the NRZ signal to thereby generate a transmission signal. In the interface device (4) on the receiver side, a detection circuit (22) detects a transmission signal to extract an NRZ modulated digital signal. A modulation method reverse conversion circuit (24) converts the NRZ signal into a bi-phase signal before outputting to the receiver device.

## Description

### TECHNICAL FIELD

The present invention relates to a network system for transmitting digital data between devices.

### BACKGROUND ART

Currently, digital data is exchanged among devices in the form of signals according to a variety of standards over an office LAN (Local Area Network) or a vehicle-mounted network. For example, as a method for modulating a digital signal in which digital data is expressed by means of variation as time passes of a voltage, an RZ (Return to Zero) method, a bi-phase method, and so forth are available, besides an NRZ (Non-Return to Zero) method in which the bit values "1" and "0" of digital data are simply made to correspond to the H (High) and L (Low) levels of the voltage, respectively.

Also, as a transmission method for use with a digital signal, there is available a broadband method, besides a baseband method for transmitting a digital signal intact, which is subjected to modulation using the above-described predetermined method, for transmitting an analogue signal obtained by modulating a carrier wave using a digital signal.

Further, a computer network for connecting a variety of digital devices other than a computer has come to be used, besides one for connecting a computer and its peripheral devices. The above-described vehicle-mounted network is one example of such a network. For example, as one standard (specification) of a vehicle-mounted network, a MOST (Media Oriented Systems Transport) system is available. In the MOST system, one ring-like network is established to which various devices including a car navigation system, a CD (a Compact Disc) player, a DVD (a Digital Versatile Disk) player, a speaker, a display, a telephone device, and so forth are connected. Then, digital data output from the CD player, for example, is utilized while being sent to the speaker via the network and converted into sound by the speaker before being output.

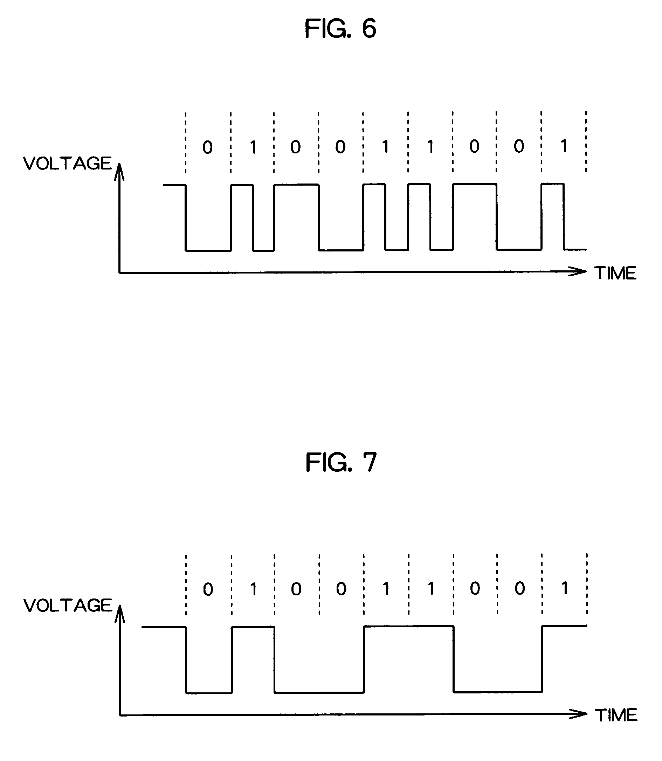

Here, a digital signal from the device can be output as a bi-phase modulated signal. The bi-phase modulation method may be referred to as an FM (Frequency Modulation) method. For example, the bit sequence "010011001" of digital data is expressed as the voltage signal shown in Fig. 6 according to bi-phase modulation. In the drawing, the vertical axis corresponds to a voltage, while the lateral axis corresponds to time.

According to the conventional art, a bi-phase modulated signal is transmitted using either the baseband method or broadband method, while the modulation method thereof is kept unchanged.

### DISCLOSURE OF INVENTION

### Problems to be Solved by the Invention

As shown in Figs. 6 and 7, a digital signal subjected to bi-phase modulation is such that the H/L levels thereof are reversed at a timing corresponding to the middle of the period for each "1". On the other hand, the voltage level is not reversed at a timing corresponding to the middle of the period for each "0", but is reversed at the boundary of each bit. As a result, the bit value "0" can correspond to either of the H or L level, while the bit value "1" is expressed so as to contain both voltage levels. Therefore, synchronization is very important in reading of the signal. This fact makes it difficult for a receiver to read a signal, and leads to a problem that a complicated detection circuit for a digital signal results on the receiver side.

The present invention has been conceived in order to solve the above-described problem, and aims to facilitate signal reading carried out on a receiver side in a network system in which a device for outputting a digital signal subjected to bi-phase modulation is connected to a node.

### Means for Solving the Problem

According to the present invention, there is provided a network system having a plurality of interface devices mutually connected via a communication path, for carrying but data transmission between node devices connected to the respective interface devices via the interface devices and the communication path, in which at least some of the node devices output transmission data in the form of a bi-phase modulated digital signal, wherein the interface device has a transmission conversion section for converting the transmission data from the node device connected to the interface device, into a transmission signal subjected to amplitude shift modulation, and outputting to the communication path.

According to another aspect of the present invention, there is provide a vehicle-mounted network system based on a MOST standard, having a plurality of interface devices mutually connected so as to together form a ring-like connection via a communication path, for carrying out data transmission between node devices connected to the respective interface devices via the interface devices and the communication path, in which at least some of the node devices output transmission data in the form of a bi-phase modulated digital signal, wherein the interface device has a transmission conversion section for converting the transmission data from the node device connected to the interface device, into a transmission signal subjected to amplitude shift modulation, and outputting to the communication path.

In the network system according to the present invention, the transmission conversion section may comprise a modulation method conversion circuit for converting the transmission data into an intermediate signal which is an NRZ modulated digital signal, and an amplitude modulation circuit for modulating an amplitude of a predetermined carrier wave according to voltage variation representing a bit sequence of the intermediate signal, to thereby generate the transmission signal.

According to a preferred aspect of the present invention, in the network system, the interface device may comprise a reception conversion section for receiving the transmission signal to be transmitted to the node device connected to the interface device, from the communication path, converting into reception data which is a bi-phase modulated digital signal, and forwarding to the node device.

According to another preferred aspect of the present invention, the node device may comprise a reception conversion section for converting the transmission signal received into reception data which is a bi-phase modulated digital signal.

According to the present invention, there is provided an interface device for use in a data communication network in which a plurality of nodes are connected to one another via a communication path, intervening, in each node, between a node device for transmission and reception of data and the communication path, comprising a transmission conversion section for converting transmission data which is output from the node device in the form of a bi-phase modulated digital signal into a transmission signal subjected to amplitude shift modulation, and outputting to the communication path.

In the transmission conversion section according to the present invention, the transmission conversion section may comprise a modulation method conversion circuit for converting the transmission data into an intermediate signal which is an NRZ modulated digital signal, and an amplitude modulation circuit for modulating an amplitude of a carrier wave according to voltage variation representing a bit sequence of the intermediate signal.

According to a preferred aspect of the present invention, the interface device may further comprise a reception conversion section for receiving the transmission signal to be transmitted to the node device connected to the interface device, from the communication path, converting into reception data which is a bi-phase modulated digital signal, and forwarding to the node device.

According to the present invention, a transmission signal subjected to bi-phase modulation according to the bit value of digital data is converted into a transmission signal which is obtained by carrying out amplitude shift modulation, for each bit, relative to a predetermined carrier wave before being output to the communication path.

### EFFECT OF THE INVENTION

With the above, a transmission signal having a constant amplitude for each bit, according to the value of the bit, results. That is, for example, the amplitude of a transmission signal remains at a constant value a1 during a period corresponding to the bit value "1", and the amplitude of the transmission signal remains at a constant value a0 during a period corresponding to the bit value "0". Therefore, the receiver side can detect the bit value simply based on whether the amplitude of the transmission is a1 or a0 without the need to give special consideration to the phase of a transmission signal.

### BRIEF DESCRIPTION OF THE DRAWINGS

Fig. 1 is a typical structural diagram showing a network system in an embodiment according to the present invention;
Fig. 2 is a block diagram showing a schematic structure of an interface device;
Fig. 3 is a diagram showing a typical signal waveform of one example of an amplitude shift modulated signal;
Fig. 4 is a typical block diagram showing a modulation method conversion circuit;
Fig. 5 is a timing chart explaining the processing carried out by the modulation method conversion circuit;
Fig. 6 is a diagram showing a typical signal waveform of one example of a digital signal subjected to bi-phase modulation; and
Fig. 7 is a diagram showing a typical signal waveform of one example of a digital signal subjected to NRZ modulation.

### BEST MODE FOR CARRYING OUT THE INVENTION

In the following, an embodiment of the present invention (hereinafter referred to as an embodiment) will be described based on the accompanied drawings.

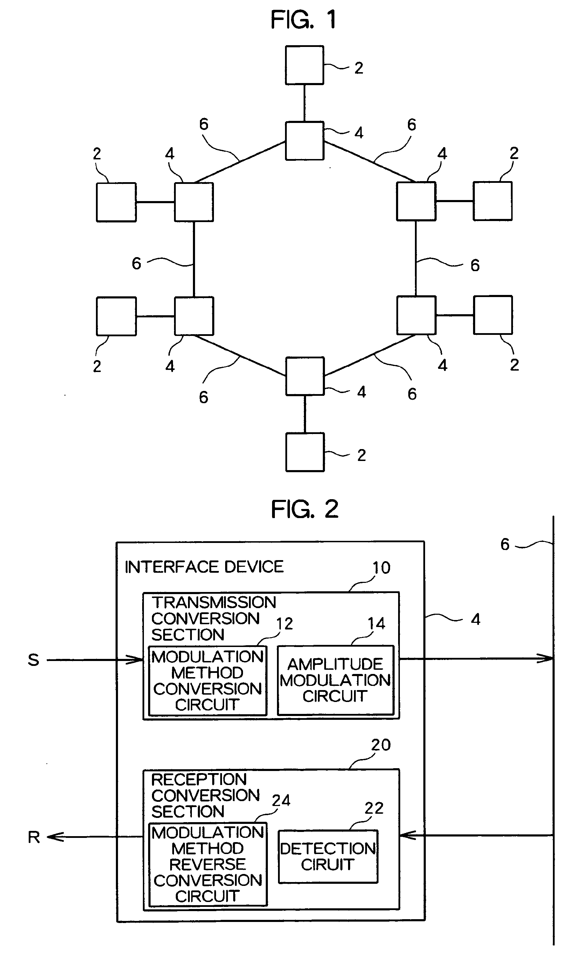

Fig. 1 is a typical structural diagram showing a network system in an embodiment according to the present invention. This network system is constituted based on, for example, the MOST standard, and correspondingly has a plurality of nodes connected thereto so as to together form a ring-like connection. Each node is constructed comprising a node device 2 and an interface device 4. The interface device 4 is directly connected to a communication path 6, while the node device 2 is connected to the communication path 6 via the interface device 4.

Through the communication path 6, transmission is carried out at the data rate of about 25 Mbps using a carrier wave of 50 MHz. The node device 2 may be a device to be utilized in an automobile, including a car navigation system, a CD player, a display, a speaker, and so forth. For example, when a music CD is reproduced using a CD player, music data is output as a digital signal from the node device 2 which is the player. The digital data is then formed into a packet by, for example, the interface device 4, and then sent to the communication path 6 with a speaker designated as a reception address.

The interface device 4 to which the speaker is connected as a node device 2 captures a packet with a speaker designated as a reception address, from among those which are transmitted over the communication path 6, and reforms the captured music data before forwarding to the node device 2.

When a bi-phase modulated signal is exchanged between two node devices 2, the corresponding interface device 4 sends a bi-phase modulated signal to the communication path 6 as an amplitude shift modulated signal which has a constant amplitude for every bit.

Fig. 2 is a block diagram showing a schematic structure of an interface device 4. The transmission data S output by the node device 2 is input to the transmission conversion section 10. The transmission conversion section 10 is constructed comprising a modulation method conversion circuit 12 and an amplitude modulation circuit 14. It should be noted that, although the transmission conversion section 10 additionally comprises a circuit or the like for reforming digital data into a packet in a predetermined format, the circuit is not shown in Fig. 2.

The modulation method conversion circuit 12 converts the transmission data S having been modulated using a bi-phase method, into a digital signal (an intermediate signal) which is modulated using an NRZ method. Figs. 6 and 7 are typical diagrams each showing a digital signal showing an example of this conversion. That is, Fig 6 shows a bit sequence "010011001" which is expressed by a bi-phase modulated signal, as described above. An intermediate signal which is an NRZ modulated signal corresponding to the bit sequence shown in Fig. 6 is shown in Fig. 7. With this conversion, a voltage at a constant H level is kept being output during a period corresponding to the bit value "1", and a voltage at a constant L level is kept being output during a period corresponding to the bit value "0".

The packet to be sent is forwarded in the form of the above-mentioned intermediate signal to the amplitude modulation circuit 14. The amplitude modulation circuit 14 modulates the amplitude of a carrier wave according to the voltage of the intermediate signal. Specifically, the amplitude a1 is employed during a period when the intermediate signal remains at a H level, and the amplitude a0 (a0<a1) is employed during a period when the intermediate signal remains at a L level.

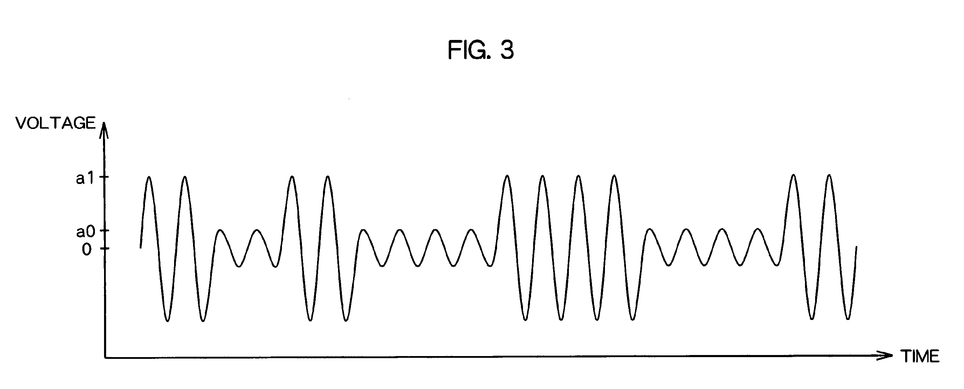

For example, Fig. 2 is a block diagram showing a schematic structure of an interface device 4. Fig. 3 is a typical diagram showing an amplitude shift modulated signal corresponding to the intermediate signal shown in Fig. 7. The transmission signal subjected to amplitude shift modulation as described above is sent from the interface device 4 to the communication path 6.

The reception conversion section 20 is constructed comprising a detection circuit 22 and a modulation method reverse conversion circuit 24. It should be noted that, although the reception conversion section 20 additionally comprises a circuit or the like for extracting a portion corresponding to transmission data, out of a digital signal representative of a packet detected by the detection circuit 22, and for reforming the reception data R, the circuit or the like is not shown in Fig. 2.

The detection circuit 22 removes a carrier wave component from a transmission signal, using a synchronism detection method, an envelope detection method, or the like, to thereby extract a digital signal which is a modulation signal component. The modulation method reverse conversion circuit 24 carries out a conversion which proceeds in a reversed manner relative to the conversion carried out by the modulation method conversion circuit 12, to thereby convert the digital signal extracted in the form of an NRZ modulated signal into a bi-phase modulated signal. The reception conversion section 20 outputs the reception data R which is a bi-phase modulated signal to a corresponding node device 2.

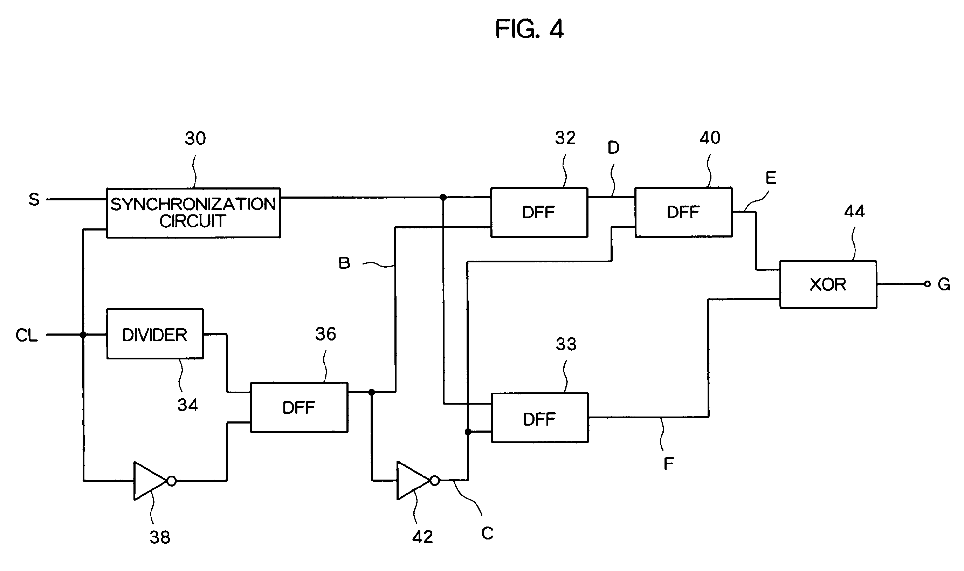

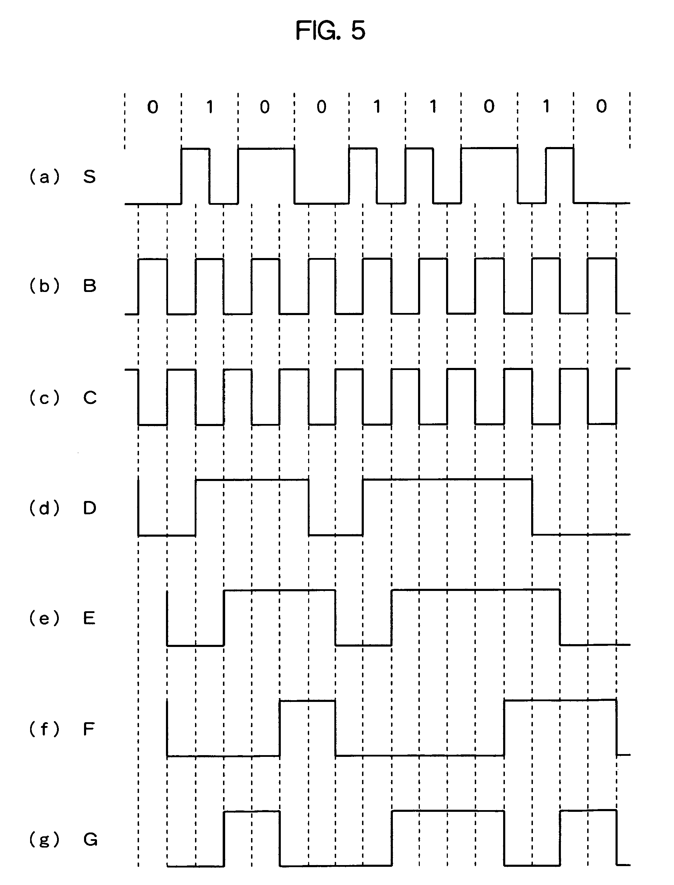

Next, a more specific structure and processing of the modulation method conversion circuit 12 will be described. Fig. 4 is a typical block diagram showing a modulation method conversion circuit 12. Also, Fig. 5 is a timing chart explaining processing by the modulation method conversion circuit 12, in which the vertical axis corresponds to a voltage level and the lateral axis corresponds to time.

The transmission data S (the signal waveform (a) of Fig. 5) subjected to bi-phase modulation is input to the modulation method conversion circuit 12, and processed in a synchronization circuit 30 such that the phase thereof is matched with that of a clock CL of 50 MHz. Thereafter, the resultant transmission data S is input to the respective data terminals of the delay flip flop (DFF) 32 and the DFF 33.

Meanwhile, the frequency divider 34 carries out 1/2 division relative to a clock CL to thereby generate a clock CL2 having 25 MHz. The clock CL2 is input to the data terminal of the DFF 36. The DFF 36 receives, via its clock terminal, a clock CL having been inverted by the inverter 38, and outputs the value input to the data terminal, in synchronism with the rising timing of the clock. As a result, a clock CL2 is output from the DEF 36 with delay of a 1/2 cycle of a clock CL.

Here, the 1/2 cycle of a clock CL corresponds to a 1/4 cycle of a clock CL2. Therefore, a clock B of 25 MHz having a signal waveform (b) of Fig. 5 with the phase thereof being delayed by 90°is obtained from the DFF 36.

The DFF 32 outputs the value of the transmission data S which is input to the data end thereof at timing corresponding to the rising of a clock B. The signal waveform (d) of Fig. 5 represents the output data D from the DFF 32. The data D is input to the DFF 40.

Meanwhile, an output B from the DFF 36 is inverted by the inverter 42, and supplied as a clock to the DFF 33 and the DFF 40. The signal waveform (c) in Fig. 5 represents an output C from the inverter 42.

The DFF 40 outputs the value of the data D at a timing corresponding to rising of a clock C. The signal waveform (e) shown in Fig. 5 represents the output data E of the DFF 40. Thereafter, the data E is input to the XOR gate (an XOR circuit) 44.

Meanwhile, the DFF 33 outputs the value of the transmission data S which is input to the data terminal thereof at a timing corresponding to the rising of a clock C. The signal waveform (f) shown in Fig. 5 represents the output data F of the DFF 33. The data F is also input to the XOR circuit 44.

The signal waveform (g) shown in Fig. 5 represents an output G of the XOR circuit 44. The digital signal G is an NRZ modulated signal corresponding to the transmission data S, and expresses the same bit sequence as that of the transmission data S, but with delay in only one cycle of the clock CL2 relative to the transmission data S.

As described above, the modulation method conversion circuit 12 generates, and outputs, an NRZ modulated signal G from transmission data S, and the amplitude modulation circuit 14 generates an amplitude shift modulated signal as shown in Fig. 3 based on the signal G.

It should be noted that although the reception conversion section 20 of the interface device 4 carries out conversion from an NRZ modulated signal to a bi-phase modulated signal in the above structure, a circuit for carrying out this conversion may be provided as being mounted to the node device 2. It is also possible to arrange such that, when the node device 2 needs a digital signal in the NRZ format, conversion to a bi-phase format is not applied.

### INDUSTRIAL APPLICABILITY

A receiver connected to a network system can detect a bit value simply based on the amplitude of a transmission signal without the need to give special consideration to the phase of the transmission signal.

## Claims

1. A network system having a plurality of interface devices mutually connected via a communication path, for carrying out data transmission between node devices connected to the respective interface devices via the interface devices and the communication path, in which at least some of the node devices output transmission data in a form of a bi-phase modulated digital signal,
wherein
the interface device has a transmission conversion section for converting the transmission data from the node device connected to the interface device, into a transmission signal subjected to amplitude shift modulation, and outputting to the communication path.

2. A vehicle-mounted network system based on a MOST standard, having a plurality of interface devices mutually connected so as to together form a ring-like connection via a communication path, for carrying out data transmission between node devices connected to the respective interface devices via the interface devices and the communication path, in which at least some of the node devices output transmission data in a form of a bi-phase modulated digital signal,
wherein
the interface device has a transmission conversion section for converting the transmission data from the node device connected to the interface device, into a transmission signal subjected to amplitude shift modulation, and outputting to the communication path.

3. The network system according to claim 1, wherein the transmission conversion section comprises:
a modulation method conversion circuit for converting the transmission data into an intermediate signal which is an NRZ modulated digital signal; and
an amplitude modulation circuit for modulating an amplitude of a predetermined carrier wave according to voltage variation representing a bit sequence of the intermediate signal, to thereby generate the transmission signal.

4. The network system according to claim 2, wherein the transmission conversion section comprises:
a modulation method conversion circuit for converting the transmission data into an intermediate signal which is an NRZ modulated digital signal; and
an amplitude modulation circuit for modulating an amplitude of a predetermined carrier wave according to voltage variation representing a bit sequence of the intermediate signal, to thereby generate the transmission signal.

5. The network system according to claim 1, wherein the interface device comprises a reception conversion section for receiving the transmission signal to be transmitted to the node device connected to the interface device, from the communication path, converting into reception data which is a bi-phase modulated digital signal, and forwarding to the node device.

6. The network system according to claim 2, wherein the interface device comprises a reception conversion section for receiving the transmission signal to be transmitted to the node device connected to the interface device, from the communication path, converting into reception data which is a bi-phase modulated digital signal, and forwarding to the node device.

7. The network system according to claim 1, wherein the node device comprises a reception conversion section for converting the transmission signal received into reception data which is a bi-phase modulated digital signal.

8. The network system according to claim 2, wherein the node device comprises a reception conversion section for converting the transmission signal received into reception data which is a bi-phase modulated digital signal.

9. An interface device for use in a data communication network in which a plurality of nodes are connected to one another via a communication path, intervening, in each node, between a node device for transmission and reception of data and the communication path, comprising:
a transmission conversion section for converting transmission data which is output from the node device in a form of a bi-phase modulated digital signal into a transmission signal subjected to amplitude shift modulation, and outputting to the communication path.

10. The interface device according to claim 9, wherein the transmission conversion section comprises:
a modulation method conversion circuit for converting the transmission data into an intermediate signal which is an NRZ modulated digital signal; and
an amplitude modulation circuit for modulating an amplitude of a carrier wave according to voltage variation representing a bit sequence of the intermediate signal.

11. The interface device according to claim 9, further comprising a reception conversion section for receiving the transmission signal to be transmitted to the node device connected to the interface device, from the communication path, converting into reception data which is a bi-phase modulated digital signal, and forwarding to the node device.
